# EUROPEAN PATENT APPLICATION

(11) **EP 1 187 522 A2**
(43) Date of publication of application: **13.03.2002**
(21) Application number: 01120952.5
(22) Date of filing: 31.08.2001
(51) Int. Cl.: H05K 7/14, A62C 3/16

(54) **Apparatus and method for shielding a pcb against fire**

(30) Priority: 06.09.2000 US 656113
(71) Applicant: Alcatel USA Sourcing, L.P., Plano, Texas 75075-5813 (US)
(72) Inventor: Wardlow, Alan, Petaluma, CA 94952 (US); Marcantel, Rodney Gene, Coppell, TX 75019 (US)
(74) Representative: Dreiss, Fuhlendorf, Steimle & Becker

(57) **Abstract**

A system and method for providing increased resistance to horizontal fire spreads in telecommunications network equipment in order to achieve compliance with the Network Equipment Building Systems (NEBS) requirements. One or more cardcage assembly units of a communications equipment are provided with printed circuit boards (PCBs) having electronic circuitry thereon, wherein a fire shield plate is mounted to the PCBs. The fire shield plate is preferably comprised of a ceramic material or a metallic sheet such as an aluminum member having a hard-anodized coating. Individual fire shield plates, removably and separately mountable to the PCBs, optimize resistance to fire spreads while minimizing cost of manufacture.

## Description

### BACKGROUND OF THE INVENTION

### Technical Field of the Invention

The present invention relates to telecommunications equipment and components and, more particularly, to a fire shield apparatus and method for suppressing horizontal fire spread in a cardcage assembly disposed in telecommunications equipment.

### Description of Related Art

Telecommunications equipment deployed in today's networks is required to comply with various governmental and industry standards not only to ensure seamless interoperability which reduces the risk of service interruption resulting from third-party product failures, but also to address various product safety issues.
Accordingly, equipment manufacturers test their products to telecom industry standards commonly known as Bellcore specifications (also sometimes referred to as Telcordia specifications) which define an extensive list of electromagnetic compliance (EMC), product safety, and environmental requirements.

The Bellcore specifications comprise two sets of testing standards, GR-1089-CORE and GR-63-CORE. The tests in GR-1089-CORE deal primarily with electrical phenomena, whereas the tests in GR-63-CORE are predominantly environmental in nature. While each set of standards is quite extensive, typically only a subset of the tests are required based on the type of equipment and its intended operating environment. Together, these two sets of standards specify the electrical and environmental requirements that networking hardware must meet in order to be located in a telco building, e.g., the telco's central office (CO).

Besides the testing requirements, which are determined by product type, Bellcore has defined additional testing levels generally referred to in the telecom industry as Telcordia's Network Equipment Building Systems (NEBS) levels. The appropriate NEBS level for a particular equipment is determined, again, by its intended operating environment and specific requirements of the Regional Bell Operating Companies (RBOCs). Generally, a higher NEBS level indicates a more stringent testing specification.

NEBS testing verifies that telecom equipment can operate successfully under certain electrical and physical environmental stresses and not pose a safety hazard to personnel and users. These stresses and hazards include earthquakes, airborne contaminants, fire and smoke, electromagnetic interference (EMI), electrical safety, and grounding.

Requirements under the three NEBS levels are summarized as follows: Level 1 includes: electrical safety; lighting and AC power fault (2^{nd} level); bonding and grounding; emissions; and fire resistance; Level 2 includes: all of Level 1 in addition to -- electrostatic discharge (ESD) under normal operation; emissions and immunity; lighting and AC power fault (1^{st} level); ambient temperature and humidity (operating); earthquake Zone 2 and office vibration; and airborne contaminants (indoor level); Level 3 includes: all of Level 1 and Level 2 in addition to - - ESD (installation and repair); open door emissions and immunity; ambient temperature and humidity (short-term); earthquake Zone 4; airborne contaminants (outdoor level); and transportation and handling. Each test within these three Levels is defined in either the GR-1089-CORE or GR-63-CORE documentation.

The flame propagation test defined in GR-63-CORE requires that when a fire starts in telecommunications equipment, e.g., a cabinet or rack unit having one or more shelves with cardcage assemblies, the fire be self-extinguished within a predetermined time limit. In order to comply with the timing requirements, the horizontal fire spread must be prevented or reduced as quickly as possible. As those skilled in the art should readily appreciate, immunity to fire spreading becomes more critical, in terms of satisfying the stringent timing requirements, where densely populated cardcage assemblies (e.g., cardcages with 32 or more printed circuit boards (PCBs) or cards such as trunk interface cards) are deployed.

Known solutions to prevent horizontal fire spreads in a cardcage assembly involve the use of metallic vertical divider plates which are integrally provided with the cardcage assembly. That is, the cardcage assembly is modified to include the vertical divider plates which are spaced to alternate between the receptacles operable to receive the PCBs in the cardcage. Accordingly, the cardcage assembly is compartmentalized such that each compartment includes one receptacle which houses a PCB card therein.

Several shortcomings and deficiencies exist in the state-of-the-art solutions. First, the existing cardcage assembly structures need to be modified to include the divider plates, which adds to the cost of manufacture significantly. Also, the use of metallic divider plates may compromise other criteria required of the unit such as, e.g., electrical robustness of the structure.

Additionally, it should be appreciated by those skilled in the art that providing compartmentalized cardcage assemblies by means of integral divider plates is not feasible where stringent form factor requirements are to be met due to, e.g., dense population of cards within the cages. Furthermore, even where such compartmentalized cardcages are deployed, their fire resistance capability has been known to be less than optimal.

### SUMMARY OF THE INVENTION

Accordingly, the present invention is directed to an innovative system and method for advantageously providing increased resistance to horizontal fire spreads in telecommunications network equipment in order to comply with the NEBS requirements. One or more cardcage assembly units of a communications equipment are provided with PCBs (or cards) having electronic circuitry thereon, wherein an individual fire shield plate is mounted to each of the PCBs. The fire shield plate is preferably comprised of a ceramic material or a metallic sheet such as an aluminum member having a hard-anodized coating. Individual fire shield plates, removably and separately mountable to the PCBs, optimize resistance to fire spreads while minimizing cost of manufacture. In a presently preferred exemplary embodiment, the fire shield plate is thin enough to be mountable on the PCBs that are disposed in densely populated cardcage assemblies (for example, carrying 32 or more cards per cage). In the embodiment where ceramic material is used, the fire shield plate is preferably about one tenth of a quarter inch in thickness. In embodiments with metallic members, a thickness of 0.020" - 0.025" is utilized, with a 0.002" hard-anodized coating for providing a dielectric surface.

In one aspect, the present invention is directed to a cardcage assembly apparatus comprising at least one PCB card having a plurality of electronic components mounted thereon, wherein the PCB card is provided to be disposable in a receptacle of the cardcage assembly apparatus. An individual fire shield plate is coupled to the PCB card for covering at least a portion said the PCB card.

In another aspect, the present invention is directed to a telecommunications network equipment tested to the NEBS fire resistance specifications, which equipment comprises an equipment shelf having one or more cardcage assembly units disposed therein. A plurality of receptacles are formed on each cardcage assembly unit for receiving PCB cards, each PCB card having two sides. In accordance with the teachings of the present invention, an individual fire shield plate is coupled to at least one of the two sides of the PCBs.

### BRIEF DESCRIPTION OF THE DRAWINGS

A more complete understanding of the present invention may be had by reference to the following Detailed Description when taken in conjunction with the accompanying drawings wherein:
FIG. 1 (Prior Art) is a cross-sectional view of a cardcage assembly with integrally provided vertical divider plates for suppressing horizontal fire spread in the compartmentalized cardcage;
FIG. 2 is a perspective view of an exemplary card assembly wherein a PCB card is provided with an individual fire shield plate in accordance with the teachings of the present invention;
FIG. 3 is another perspective view of the exemplary card assembly wherein a PCB card is provided with an individual fire shield plate in accordance with the teachings of the present invention;
FIGS. 4A and 4B are two views of another exemplary card assembly provided in accordance with the teachings of the present invention;
FIG. 5 depicts a flow chart of the steps of involved in reducing susceptibility to horizontal fire spreads in a cardcage assembly of the present invention; and
FIG. 6 is a cross-sectional view of an exemplary cardcage assembly provided in accordance with the teachings of the present invention.

### DETAILED DESCRIPTION OF THE DRAWINGS

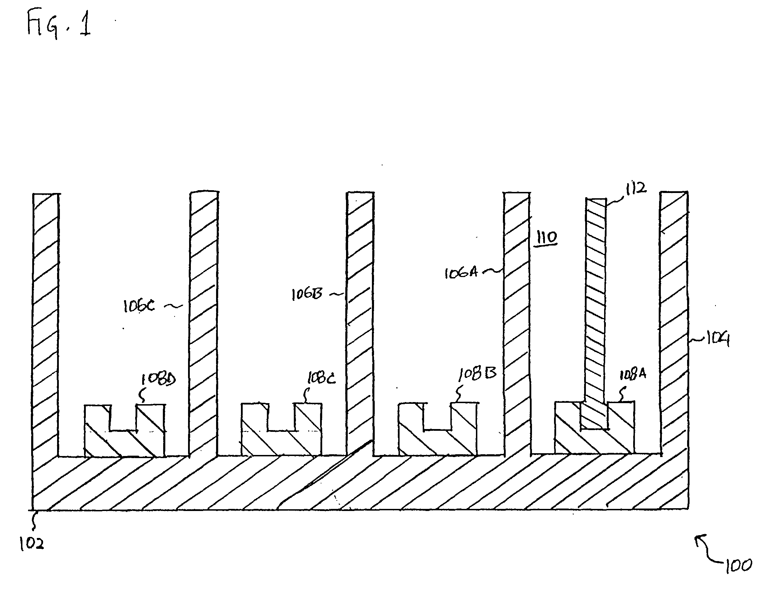

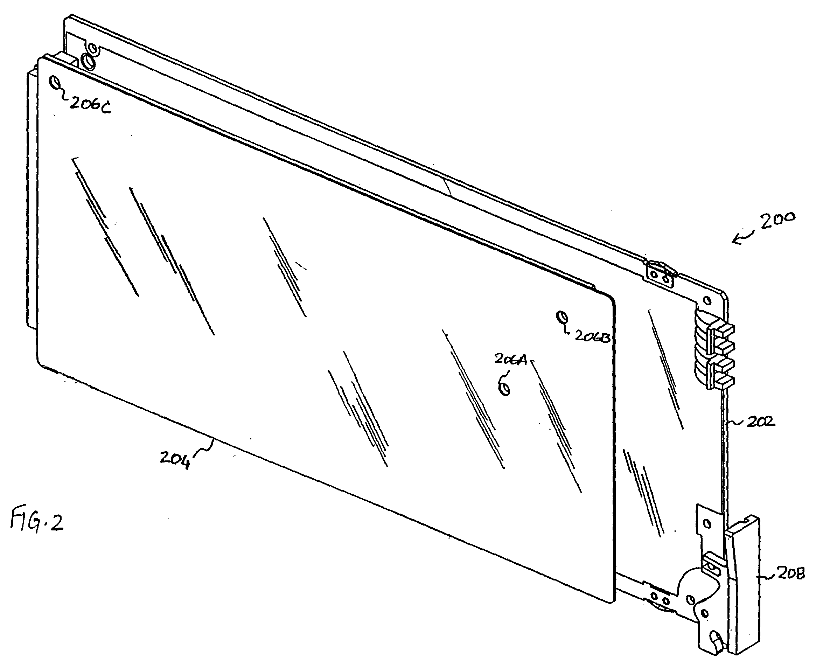

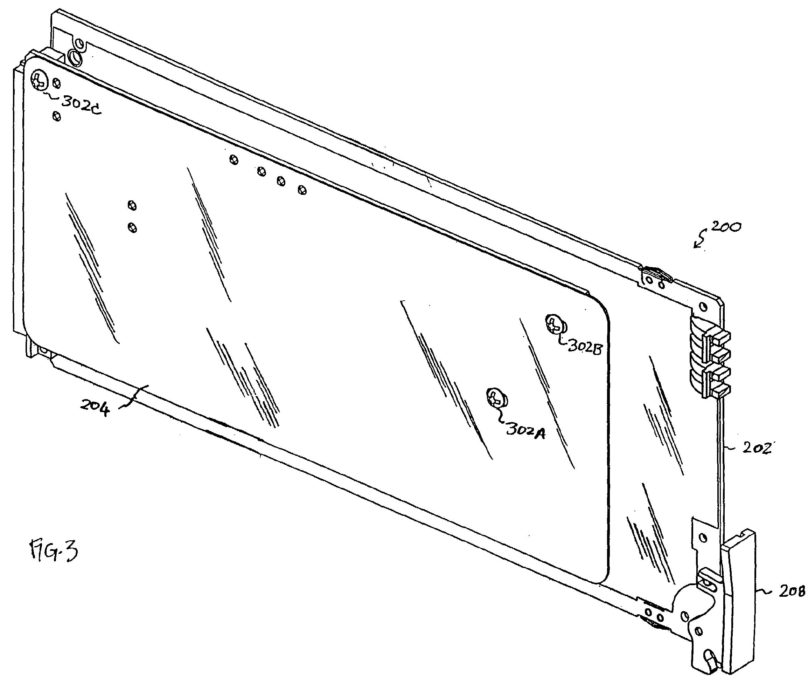

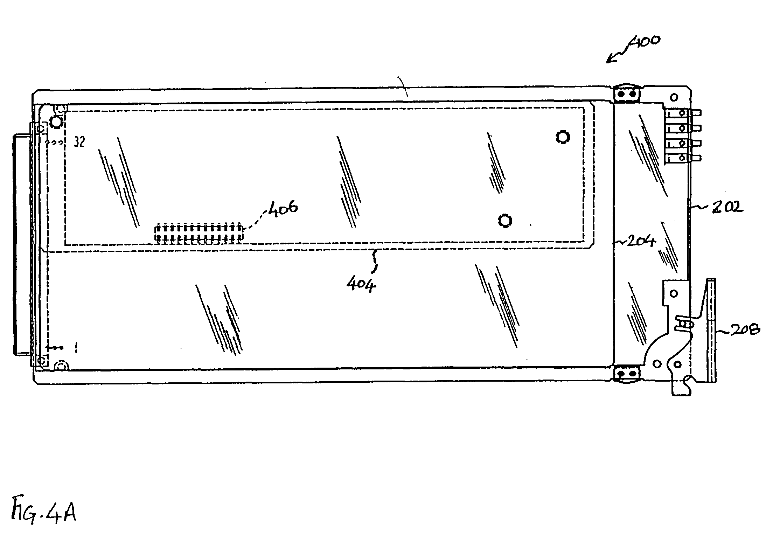

In the drawings, like or similar elements are designated with identical reference numerals throughout the several views thereof, and the various elements depicted are not necessarily drawn to scale. Referring now to FIG. 1, depicted therein is a cross-sectional view of a cardcage assembly 100 for preventing the horizontal spread of fire in equipment in accordance with the state-of-the-art solutions. A plurality of card receptacles (for example, reference numerals 108A through 108D) are disposed on a backplane 102 of the cardcage assembly's housing 104 for receiving PCB cards. In the embodiment depicted in FIG. 1, a single PCB card 112 is exemplified for illustrative purposes, wherein the placement of card's electronic components or circuitry is omitted for the sake of clarity.

A plurality of vertical divider plates (for example, metallic divider plates 106A - 106C) are integrally provided with the conventional cardcage assembly 100 such that the space encompassed by the housing 104 is compartmentalized, whereby a card receptacle and its PCB card are isolated from adjacent receptacle/card arrangements by means of the divider plates. For example, the receptacle 108A and its card 112 are disposed in compartment 110 and, accordingly, are isolated from the remaining cards.

As alluded to in the Background section of the present patent application, conventional solutions for reducing fire propagation such as the cardcage assembly arrangement with vertical divider plates described above are beset with several deficiencies and drawbacks.

Referring now to FIG. 2, depicted therein is a perspective view of an exemplary card assembly 200 wherein an individual fire shield plate 204 is advantageously provided with a PCB card 202 in accordance with the teachings of the present invention. The PCB card 202 is comprised of a circuit board member having electronic circuitry for any known or hitherto unknown functionality, and is preferably provided with conventional means such as a toggle clip or snap (e.g., reference numeral 208) for securing the card to a chassis when the card is disposed in its receptacle.

The fire shield plate 204 is preferably provided to be customizable and dimensionable with respect to the size and functionality of the PCB card 202. In one preferred exemplary embodiment, the fire shield plate 204 is comprised of ceramic material having a thickness of about 0.025". Other preferred exemplary embodiments of the fire shield plate 204 include hard-anodized metallic members such as, for example, an aluminum sheet of about 0.020" - 0.025" thick having a hard-anodized coating of about 0.002". In general, the fire shield plate 204 may also be comprised of a dielectric material, or a member that is coated with a dielectric layer.

Preferably, the fire shield plate 204 substantially covers or overlaps the PCB card 202 and is securely coupled to it by any known or hitherto unknown coupling means. For example, screws, snaps, latches, bolts, adhesive members, clips, clamps, clasps, fasteners, braces, grips, et cetera, may be utilized in accordance herewith for attaching the fire shield plate 204 to the PCB card 202. Where necessary, a plurality of holes or apertures may be provided in the fire shield plate 204 for fastening purposes. For example, holes 206A - 206C are accordingly exemplified in the embodiment depicted in FIG. 2.

FIG. 3 depicts another perspective view of the exemplary card assembly 200 described hereinabove, wherein three screws (reference numerals 302A - 302C) are illustratively provided for securing the fire shield plate 204 to the substrate body of the PCB card 202.

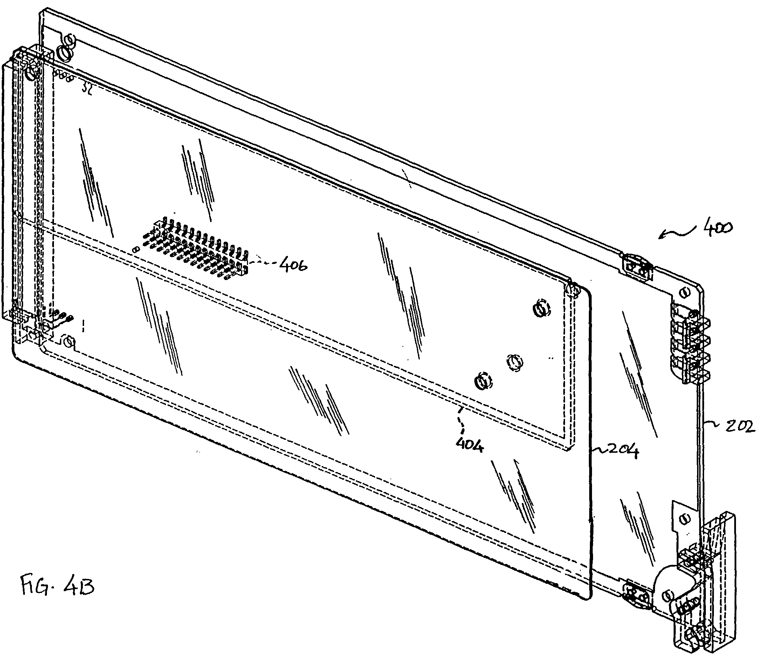

FIGS. 4A and 4B depict two views of another exemplary card assembly 400 provided in accordance with the teachings of the present invention. In this exemplary embodiment, a daughter card 404 is coupled to the PCB card 202 via a connector 406, as is common in some customer applications. The fire shield plate 204 of the present invention is operably disposed in this exemplary embodiment with respect to the cards such that the daughter card 404 is placed in between the fire shield plate 204 and the PCB card 202. However, those skilled in the art should readily recognize that in some other embodiments the PCB card may be placed in between the daughter card and fire shield plate, and that there may be multiple daughter cards as well. Furthermore, the fire shield plate 204 may be secured to both of the PCB and daughter cards, or any one of them in any combination of coupling means.

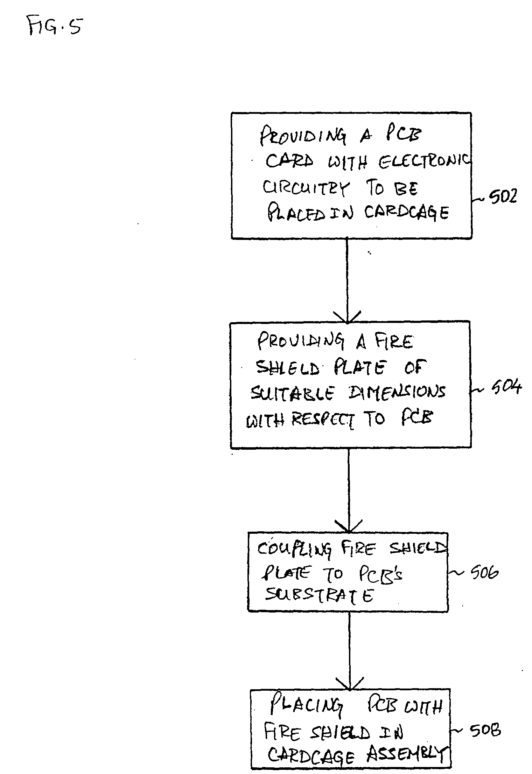

Referring now to FIG. 5, depicted therein is a flow chart of the steps involved in reducing susceptibility to horizontal fire spreads in a cardcage assembly in accordance with the teachings of the present invention. As set forth above, any known or hitherto unknown PCB card assembly with applicable electronic circuitry is provided for placement within a cardcage assembly (step 502).
Preferably, no structural modifications to the cardcage are required, although the teachings of the present invention are not necessarily limited to the absence of such structural modifications and, therefore, can also be practiced in conjunction with whatever modifications there may be.

An individual fire shield plate is then separately provided for coupling with the PCB card as described in greater detail hereinabove (step 504). It should be recognized that in some implementations, two fire shield plates may be coupled to each PCB card, one disposed on each side thereof. Also, where so provided, the two fire shield plates need not be identical in composition, size, shape, or other dimensions.

The fire shield plate or plates are coupled or mounted to the PCB card in any manner as set forth in the foregoing (step 506). Where plural cards are provided in a card assembly (e.g., involving daughter cards), the mounting may involve either or both of the mother and daughter cards. Thereafter, the card assembly is placed in the cardcage assembly by means of receptacles disposed therein (step 508).

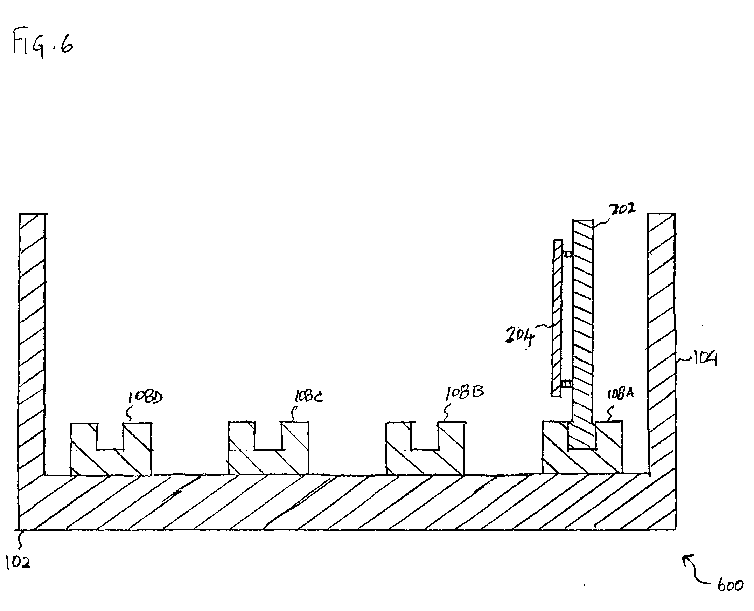

FIG. 6 depicts a cross-sectional view of an exemplary cardcage assembly 600 provided in accordance with the teachings of the present invention set forth hereinabove, wherein the single PCB card 202 with the fire shield plate 204 mounted to one side thereof is illustrated.

Based on the foregoing, it should be appreciated that the present invention advantageously provides an effective yet economical solution for preventing horizontal fire spread in telecommunications equipment. The dielectric nature of the fire shield plate material imparts sufficient fire resistance capability to the cardcage assemblies disposed in the shelves of the rack equipment such that fires are self-extinguished within the time limits required under the NEBS tests.

It should be further appreciated that individual fire shield plates, separately mountable to PCBs, are advantageous over vertical divider plates because of less cost and optimal fire resistance performance. Moreover, better form factor compliance is achieved by the use of individually mountable fire shield plates in dense cardcage applications where space constraints are critical and often depend on customer application configurations.
Additionally, the capability of individually mounting the fire shield plates to PCB cards gives rise to highly flexible and customizable fire resistance applications.

It is believed that the operation and construction of the present invention will be apparent from the foregoing Detailed Description. While the apparatus and method shown and described have been characterized as being preferred, it should be readily understood that various changes, modifications and enhancements could be made therein without departing from the scope of the present invention as set forth in the following claims. For example, it is possible to use different metals and/or metallic combinations as substrates for the anodized fire shield plates. Further, the teachings of the present invention can also be practiced in conjunction with the vertical divider plate solutions. Additionally, although the motivation for the present invention has been set forth in the context of telecommunications network equipment, it should be appreciated that the teachings hereof may be practiced in any equipment. Accordingly, those skilled in the art should readily appreciate that these and other variations, additions, modifications, enhancements, et cetera, are deemed to be within the ambit of the present invention whose scope is determined solely by the following claims.

## Claims

1. A cardcage assembly apparatus, comprising:
at least one printed circuit board (PCB) having a plurality of electronic components mounted thereon, said at least one PCB being disposable in a receptacle of said cardcage assembly apparatus; and
a fire shield plate mounted to said at least one PCB, said fire shield plate for covering at least a portion said at least one PCB.

2. The cardcage assembly apparatus as set forth in claim 1, wherein said at least one PCB forms a line interface card of a telecommunications equipment.

3. The cardcage assembly apparatus as set forth in claim 2, wherein said fire shield plate is comprised of a ceramic material.

4. The cardcage assembly apparatus as set forth in claim 2, wherein said fire shield plate is comprised of an anodized metallic sheet.

5. The cardcage assembly apparatus as set forth in claim 4, wherein said anodized metallic sheet comprises a dielectric-coated aluminum member.

6. The cardcage assembly apparatus as set forth in claim 2, wherein said fire shield plate is about one tenth of a quarter inch in thickness.

7. The cardcage assembly apparatus as set forth in claim 2, wherein said fire shield plate is comprised of a material having a hard-anodized coating on its surface.

8. The cardcage assembly apparatus as set forth in claim 2, wherein said fire shield plate is comprised of a material having a dielectric surface.

9. The cardcage assembly apparatus as set forth in claim 2, wherein said fire shield plate is mounted to said at least one PCB by at least one screw.

10. The cardcage assembly apparatus as set forth in claim 2, wherein said fire shield plate is mounted to said at least one PCB by coupling means.

11. A telecommunications network equipment, comprising:
an equipment shelf having a cardcage assembly unit disposed therein;
a plurality of receptacles formed on said cardcage assembly unit for receiving printed circuit boards (PCBs), each PCB having two sides; and
a fire shield plate mounted to at least one of said two sides of each of said PCBs.

12. The telecommunications network equipment as set forth in claim 11, wherein said fire shield plate overlaps a substantial portion of said at least one of said two sides.

13. The telecommunications network equipment as set forth in claim 11, wherein said fire shield plate comprises a material with a dielectric surface.

14. The telecommunications network equipment as set forth in claim 11, wherein said fire shield plate comprises a ceramic material.

15. The telecommunications network equipment as set forth in claim 11, wherein said fire shield plate is about one tenth of a quarter inch in thickness.

16. The telecommunications network equipment as set forth in claim 11, wherein said fire shield plate comprises a material with a dielectric surface.

17. The telecommunications network equipment as set forth in claim 11, wherein said fire shield plate comprises a material with a hard-anodized coating disposed on its surface.

18. The telecommunications network equipment as set forth in claim 11, wherein each side of said PCBs is provided with said fire shield plate.

19. The telecommunications network equipment as set forth in claim 11, wherein said fire shield plate is mounted to each of said PCBs by coupling means.

20. The telecommunications network equipment as set forth in claim 11, wherein said fire shield plate is integrally mounted to each of said PCBs.

21. A method of increasing resistance to horizontal fire spread in telecommunications equipment, comprising the steps of:
providing a cardcage assembly unit for housing a plurality of printed circuit boards (PCBs) therein, each of said PCBs having electronic components mounted thereon; and
coupling a fire shield plate to each of said PCBs wherein a substantial portion of said electronic components is covered thereby.

22. The method of increasing resistance to horizontal fire spread in telecommunications equipment as set forth in claim 21, wherein said fire shield plate is integrally coupled to each of said PCBS.

23. The method of increasing resistance to horizontal fire spread in telecommunications equipment as set forth in claim 21, wherein said fire shield plate is removably coupled to each of said PCBs.

24. The method of increasing resistance to horizontal fire spread in telecommunications equipment as set forth in claim 21, wherein both sides of each of said PCBs is provided with said fire shield plate.

25. The method of increasing resistance to horizontal fire spread in telecommunications equipment as set forth in claim 21, wherein said fire shield plate is coupled to each of said PCBs by coupling means.

26. The method of increasing resistance to horizontal fire spread in telecommunications equipment as set forth in claim 21, wherein said fire shield plate comprises a ceramic material.

27. The method of increasing resistance to horizontal fire spread in telecommunications equipment as set forth in claim 21, wherein said fire shield plate comprises a material having a dielectric surface.

28. The method of increasing resistance to horizontal fire spread in telecommunications equipment as set forth in claim 21, wherein said fire shield plate comprises a material having a hard-anodized surface.

29. The method of increasing resistance to horizontal fire spread in telecommunications equipment as set forth in claim 29, wherein said material comprises aluminum.

30. The method of increasing resistance to horizontal fire spread in telecommunications equipment as set forth in claim 21, wherein said fire shield plate is about one tenth of a quarter inch in thickness.

31. The method of increasing resistance to horizontal fire spread in telecommunications equipment as set forth in claim 21, wherein said fire shield plate comprises a metallic sheet having a hard-anodized surface.
